# EUROPEAN PATENT APPLICATION

(11) **EP 4 738 361 A2**
(43) Date of publication of application: **06.05.2026**
(21) Application number: 25212154.6
(22) Date of filing: 29.10.2025
(51) Int. Cl.: G11C 11/16

(54) **CONFIGURATION BIT HAVING A PLURALITY OF MAGNETORESISTIVE DEVICES, AND METHODS OF PROGRAMMING AND READING THE SAME**

(30) Priority: 30.10.2024 US 202463713797 P; 28.10.2025 US 202519370982
(71) Applicant: Everspin Technologies, Inc., Chandler, Arizona 85226 (US)
(72) Inventor: SADD, Michael A., Chandler, AZ 85226 (US); ALBRIGHT, Keith, Chandler, AZ 85226 (US); ALAM, Syed M., Chandler, AZ 85226 (US); HUTCHISON, Brian, Chandler, AZ 85226 (US); DO, Vincent, Chandler, AZ 85226 (US)
(74) Representative: Eisenführ Speiser

(57) **Abstract**

A method for programming a configuration bit including magnetic tunnel junctions (MTJs), including during a first phase: applying a first voltage to a first leg of MTJs and a third leg of MTJs to program or inhibit the MTJs of the first leg and the third leg, and applying a second voltage to a second leg of MTJs and a fourth leg of MTJs to program or inhibit the MTJs of the second leg and the fourth leg. During a second phase: applying the second voltage to the first leg of MTJs and the third leg of MTJs to program or inhibit the MTJs of the first leg and the third leg, and applying the first voltage to the second leg of MTJs and the fourth leg of MTJs to program or inhibit the MTJs of the second leg and the fourth leg.

## Description

### CROSS-REFERENCE TO RELATED APPLICATION

This application claims benefit to U.S. Non-Provisional Patent Application No. 19/370,982, filed October 28, 2025, which claims priority to U.S. Provisional Patent Application No. 63/713,797 filed October 30, 2024, the entire contents of which are incorporated herein by reference.

### TECHNICAL FIELD

The present disclosure relates generally to systems and methods for a memory device, and, more particularly, programming configuration bits of a memory device.

### INTRODUCTION

Each integrated circuit chip may include billions of devices thereon, including memory devices such as magnetoresistive tunnel junctions (MTJs). Memory devices may include configuration bits that utilize MTJs to store configuration data for controlling various circuit operations. Each configuration bit may include multiple MTJs arranged in legs, where each leg contains one or more MTJs connected in series. Programming configuration bits may involve applying voltages to simultaneously program multiple legs of MTJs, which may require drivers and circuit components to handle increased current loads when multiple legs are programmed concurrently.

When programming multiple legs of MTJs simultaneously, drivers connected to shared nodes between legs may need to support current drawn by more than one leg at the same time. This may require larger driver components capable of handling the increased current, which may result in increased circuit area and higher power consumption. Additionally, MTJs may experience defects during the manufacturing process, or may experience damage throughout the lifetime of the device, that may adversely affect the operation of a memory device. Defects or damage may include, for example, short or open defects. A short defect causes unintentional electrical contact between layers of an MTJ (e.g., the MTJ may constantly conduct electrical current), while an open defect causes an MTJ to act as an open switch (e.g., no electrical conduction therein). Both short and open defects can adversely affect or destroy MTJ performance.

The need for larger components to support simultaneous programming of multiple MTJ legs may adversely affect the overall efficiency and area utilization of memory devices. Therefore, it may be desirable to have configuration bit designs that can reduce the current requirements for individual drivers while maintaining programming functionality. Furthermore, it may be desirable to achieve such designs in a manner that allows for smaller component sizes and reduced overall circuit area without requiring enlarged components.

### BRIEF DESCRIPTION OF DRAWINGS

In the course of the detailed description that follows, reference will be made to the appended drawings. The drawings show different aspects of the present disclosure and, where appropriate, reference numerals illustrating like structures, components, materials, and/or elements in different figures are labeled similarly. It is understood that various combinations of the structures, components, and/or elements, other than those specifically shown, are contemplated and are within the scope of the present disclosure.

Moreover, there are many embodiments of the present disclosure described and illustrated herein. The present disclosure is neither limited to any single aspect nor embodiment thereof, nor to any combinations and/or permutations of such aspects and/or embodiments. Moreover, each of the aspects of the present disclosure, and/or embodiments thereof, may be employed alone or in combination with one or more of the other aspects of the present disclosure and/or embodiments thereof. For the sake of brevity, certain permutations and combinations are not discussed and/or illustrated separately herein; however, all permutations and combinations are considered to fall within the scope of the present inventions.
FIG. 1 depicts an exemplary circuit schematic of a configuration bit, according to one or more embodiments.
FIG. 2 depicts an exemplary configuration bit implementing a two-pass program for area reduction, according to one or more embodiments.
FIG. 3 depicts an exemplary configuration bit implementing a two-pass program for area reduction, according to one or more embodiments.
FIGS. 4A and 4B depict plot measurements corresponding to a two-pass program of FIGS. 2-3, according to one or more embodiments.
FIG. 5 depicts a layout of a configuration bit with write circuit perpendicular to read circuit.

Again, there are many embodiments described and illustrated herein. The present disclosure is neither limited to any single aspect nor embodiment thereof, nor to any combinations and/or permutations of such aspects and/or embodiments. Each of the aspects of the present disclosure, and/or embodiments thereof, may be employed alone or in combination with one or more of the other aspects of the present disclosure and/or embodiments thereof. For the sake of brevity, many of those combinations and permutations are not discussed separately herein.

### DETAILED DESCRIPTION

Detailed illustrative aspects are disclosed herein. However, specific structural and functional details disclosed herein are merely representative for purposes of describing example embodiments of the present disclosure. The present disclosure may be embodied in many alternate forms and should not be construed as limited to only the embodiments set forth herein. Further, the terminology used herein is for the purpose of describing particular embodiments only and is not intended to be limiting of exemplary embodiments described herein.

When the specification makes reference to "one embodiment" or to "an embodiment," it is intended to mean that a particular feature, structure, characteristic, or function described in connection with the embodiment being discussed is included in at least one contemplated embodiment of the present disclosure. Thus, the appearance of the phrases, "in one embodiment" or "in an embodiment," in different places in the specification does not constitute a plurality of references to a single embodiment of the present disclosure.

As used herein, the terms "comprises," "comprising," or any other variation thereof, are intended to cover a non-exclusive inclusion, such that a process, method, article, or apparatus that comprises a list of elements does not include only those elements, but may include other elements not expressly listed or inherent to such process, method, article, or apparatus. The term "exemplary" is used in the sense of "example," rather than "ideal."

As used herein, the singular forms "a," "an," and "the" are intended to include the plural forms as well, unless the context clearly indicates otherwise. It also should be noted that in some alternative implementations, the features and/or steps described may occur out of the order depicted in the figures or discussed herein. For example, two steps or figures shown in succession may instead be executed substantially concurrently or may sometimes be executed in the reverse order, depending upon the functionality/acts involved. In some aspects, one or more described features or steps may be omitted altogether, or may be performed with an intermediate step therebetween, without departing from the scope of the embodiments described herein, depending upon the functionality/acts involved.

Further, the terms "first," "second," and the like, herein do not denote any order, quantity, or importance, but rather are used to distinguish one element from another. Similarly, terms of relative orientation, such as "top," "bottom," etc. are used with reference to the orientation of the structure illustrated in the figures being described. It should also be noted that all numeric values disclosed herein may have a variation of ±10% (unless a different variation is specified) from the disclosed numeric value. Further, all relative terms such as "about," "substantially," "approximately," etc. are used to indicate a possible variation of ±10% (unless noted otherwise or another variation is specified).

In the interest of conciseness, conventional techniques, structures, and principles known by those skilled in the art may not be described herein, including, for example, standard magnetoresistive random access memory (MRAM) process techniques, generation of bias voltages, fundamental principles of magnetism, and basic operational principles of memory devices.

For the sake of brevity, conventional techniques related to accessing (e.g., reading or writing) memory, and other functional aspects of certain systems and subsystems (and the individual operating components thereof) may not be described in detail herein. Furthermore, the connecting lines shown in the various figures contained herein are intended to represent exemplary functional relationships and/or physical couplings between the various elements. It should be noted that many alternative or additional functional relationships or physical connections may be present in an embodiment of the subject matter.

The magnetic tunnel junction (MTJ) is a fundamental unit of a memory array and may include, among other things, two magnetic layers on opposite sides of an insulator. The two magnetic layers may include a fixed magnetic layer (also known as the reference layer) with a fixed magnetic moment and a free layer with a non-fixed magnetic moment. By changing the direction of the magnetic moment of the free layer, the logical state of the MTJ may be changed (also known as "programming" or "writing" the MTJ). The two separate states exhibit different resistance magnitudes. Generally, when the fixed and free layer have a parallel magnetic orientation, the resistance is lower than when the free layer is anti-parallel to the fixed layer. This resistance change can be used to sense and distinguish the two resistance states into a logical state.

An MTJ bit, such as a configuration bit, may include multiple MTJs that may be electrically connected together. The logical state of the MTJ bit may be based on the differences in polarities of the individual MTJs in an MTJ bit. An MTJ bit may be electrically connected to a read device, which reads the logical state of the MTJ bit based on comparisons of the relative magnetic polarities between sets of MTJs in the MTJ bit. Based on the results of that comparison, the read device will read (or "sense") a logical state corresponding to the logical state of the MTJ bit.

Embodiments of the present disclosure may be configured to program a plurality of legs of MTJs at the same time by applying different voltages (e.g., a bias voltage and/or a reference voltage (Vdd)), which may cause the plurality of MTJs to draw current at the same time. In an embodiment, drivers may be connected to nodes that are shared between more than one leg of MTJs (e.g., more than one pair of MTJs). While programming MTJs within a leg, a current may flow in series through all of the MTJs and the drivers, which may require the drivers used to be sized (e.g., designed) to support an increased current that may be drawn by the plurality of MTJs to be programmed. An internal impedance of each driver may impact the size of the drivers, which may be taken into consideration when designing a system. An area of the drivers connected to nodes that are shared with more than one pair of MTJs may require a larger area than the area of drivers connected to nodes that are not connected to more than one leg of MTJs because of the total current to be drawn by the multiple legs of MTJs.

In an embodiment, multiple legs of MTJs may be programmed in a two-pass (or two phase) operation where a first half of the multiple legs of MTJs may be programmed in a first pass (or first phase) and a second half of the multiple legs of MTJs (e.g., the MTJs that were not programmed in the first pass) may be programmed in the second pass (or second phase). In an embodiment, MTJs of a configuration bit may be arranged in two sides (e.g., a left side and a right side), each side including two or more legs of MTJs. The two or more legs of MTJs in each side may not be configured to be programmed at the same time, and thus the write drivers and/or corresponding nodes may not be required to support current drawn by two or more legs of MTJs at the same time. This may allow for the write drivers and/or corresponding nodes to be sized to support only current that would be drawn by one leg of MTJs. This may allow for the write drivers to be sized smaller than the size needed to support current drawn by two or more legs of MTJs being programmed at the same time.

In an embodiment, programming MTJs of a configuration in two phases may take longer than programming the MTJs in only one phase (e.g., programming all MTJs at the same time). However, a factor (e.g., amount of current to support) of at least a portion of the drivers and/or nodes that are shared by more than one leg of MTJs may be reduced by half (e.g., from a factor = 2, to a factor = 1). In an embodiment, a configuration bit with a two pass (or two phase) program for area reduction may re-use a signal that may have been inactive to decide which step of the two passes to perform. For example, a re-used signal may include a read, a write, or a data signal.

Embodiments of the present disclosure may enable configuration bit devices capable of having a smaller area than devices configured to program all MTJs at one time. Some embodiments disclosed herein may require twice the time to write each configuration bit than conventional devices, but may draw half the current of conventional devices. However, the same write throughput may be achieved by programming twice the cells at a time. In an embodiment, a memory device may include multiple configuration bit design blocks utilizing two pass writes (e.g., the two-phase program) being performed concurrently in multiple configuration bit blocks. This may provide for a timing penalty to be eliminated while taking advantage of an area reduction.

Embodiments of the present disclosure may also include the following aspects. By reducing the size of the memory device components (e.g., MTJs, write drivers, etc.), a reduction in the overall size and arrangement of the read and program devices may be achieved. For example, by reducing the size of each memory device component, the reduction in each program device and read device may allow for a reduction in the overall area used per device. In addition, the orientation of the program and read devices may provide an added benefit of optimizing the overall size and layout of the memory device(s). In one embodiment, the program device(s) may be permitted to be arranged perpendicular relative to the read device(s) to optimize the length requirements of each device in addition to maximizing the diffusion area associated with the memory device.

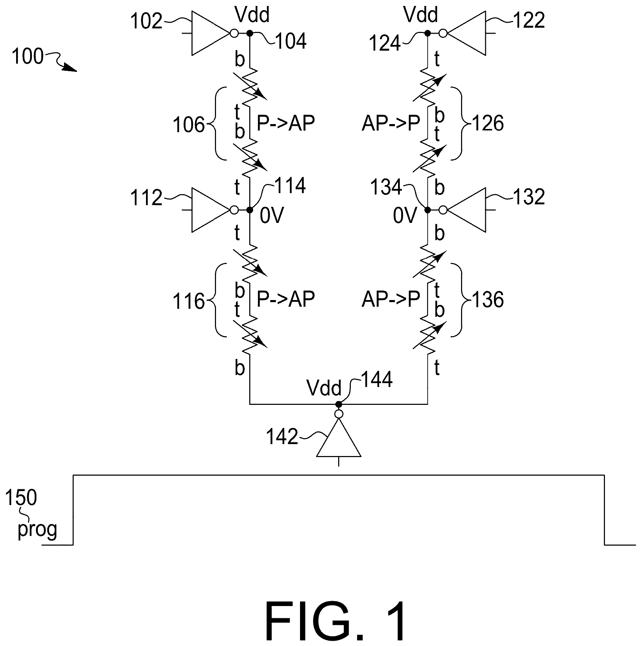

FIG. 1 depicts an exemplary circuit schematic of a configuration bit, according to one or more embodiments. A memory device 100 (e.g., configuration bit 100) may include a first node 104, a second node 114, a third node 144, a fourth node 134, and a fifth node 124. First node 104 may be connected to a first driver 102. Second node 114 may be connected to a second driver 112. Third node 144 may be connected to a third driver 142. Fourth node 134 may be connected to a fourth driver 132. Fifth node 124 may be connected to a fifth driver 122. The drivers depicted in FIG. 1 may include write drivers for programming the MTJs. These drivers (102, 112, 122, 132, 142) are depicted as inverters, but may differ from an inverter in detail. For example, the drivers may be configured to tri-state their output. A first leg 106 may be connected to first driver 102 at first node 104 and second driver 112 at second node 114. Stated differently, first leg 106 may be disposed between first driver 102 and second driver 112, connecting first node 104 to second node 114. First leg 106 may include one or more MTJs connected in series connecting first node 104 to second node 114.

A second leg 116 may be connected to second driver 112 at second node 114 and third driver 142 at third node 144. Stated differently, second leg 116 may be disposed between second driver 112 and third driver 142, connecting second node 114 to third node 144. Second leg 116 may include one or more MTJs connected in series connecting second node 114 to third node 144. A third leg 136 may be connected to third driver 142 at third node 144 and fourth driver 132 at fourth node 134. Stated differently, third leg 136 may be disposed between third driver 142 and fourth driver 132, connecting third node 144 to fourth node 134. Third leg 136 may include one or more MTJs connected in series connecting third node 144 to fourth node 134. A fourth leg 126 may be connected to fourth driver 132 at fourth node 134 and fifth driver 122 at fifth node 124. State differently, fourth leg 126 may be disposed between fourth driver 132 and fifth driver 122, connecting fourth node 134 to fifth node 124. Fourth leg 126 may include one or more MTJs connected in series connecting fourth node 134 to fifth node 124.

Each of the one or more MTJs of each leg (e.g., first leg 106, second leg 116, third leg 136, and fourth leg 126) may include one or more operating states. For example, an MTJ may operate in a low-resistance state (e.g., parallel) or high-resistance state (e.g., antiparallel). Based on the voltages applied at each node (which are supplied by the write drivers) and the resultant current, the state of each MTJ may be changed from parallel to antiparallel or vice versa. Each leg (e.g., first leg 106, second leg 116, third leg 136, and fourth leg 126) may include fewer or more MTJs relative to the examples explicitly discussed herein, and such modification may be consistent with the operation of the present embodiment without departing from the scope of the disclosure.

Still referring to FIG. 1, each leg of configuration bit 100 may be programmed in a single pass or phase. To program the one or more MTJs within each leg of configuration bit 100, different voltages may be applied at the nodes (e.g., first node 104, third node 144, or fifth node 124). Such programming may take place at the time when the program signal 150 is provided. Supply voltage (e.g., Vdd) may be provided at one or more nodes (e.g., first node 104, third node 144, and fifth node 124) such that each leg (e.g., first leg 106, second leg 116, third leg 136, and fourth leg 126) receives a current in a desired direction in a single pass or phase. For example, upon receiving the supply voltage, first leg 106 and second leg 116 may change their respective operating states from parallel to antiparallel. Similarly, upon receiving the supply voltage, third leg 136 and fourth leg 126 may change their respective operating states from antiparallel to parallel. The use of a single pass or phase program may allow for reduction in time for programing the configuration bit 100. However, the reduction in time may require larger components (e.g., write drivers) to handle the voltage requirements to program all legs of the configuration bit simultaneously.

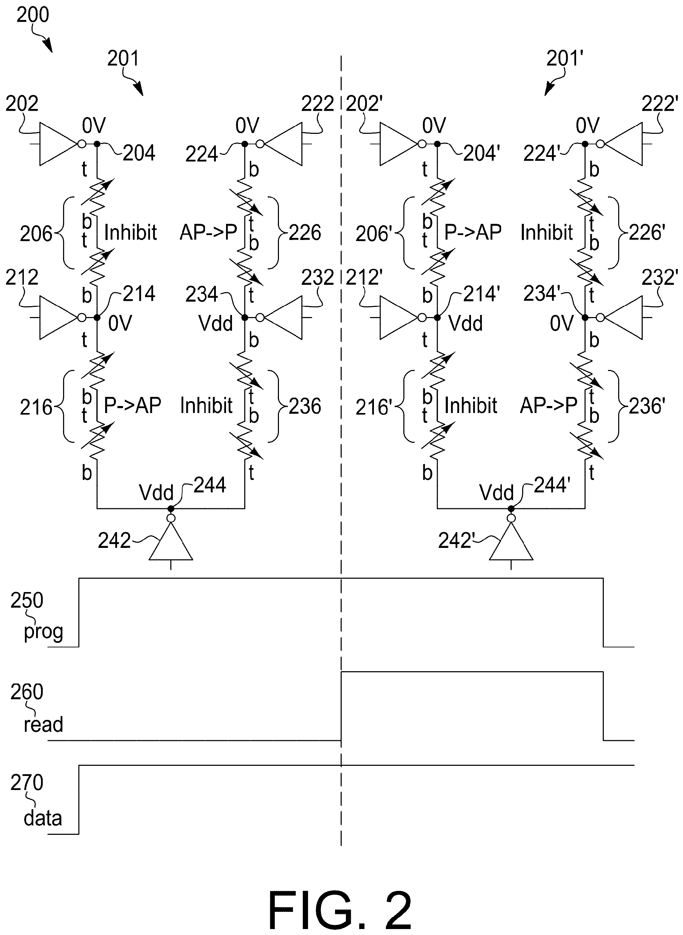

FIG. 2 depicts an exemplary circuit schematic of a configuration bit, according to one or more embodiments. A memory device 200 (e.g., configuration bit 200) may include a first node 204, a second node 214, a third node 244, a fourth node 234, and a fifth node 224. First node 204 may be connected to a first driver 202. Second node 214 may be connected to a second driver 212. Third node 244 may be connected to a third driver 242. Fourth node 234 may be connected to a fourth driver 232. Fifth node 224 may be connected to a fifth driver 222. The drivers depicted in FIG. 2 may include write drivers for programming the MTJs. A first leg 206 may be connected to first driver 202 at first node 204 and second driver 212 at second node 214. Stated differently, first leg 206 may be disposed between first driver 202 and second driver 212, connecting first node 204 to second node 214. First leg 206 may include one or more MTJs connected in series connecting first node 204 to second node 214.

A second leg 216 may be connected to second driver 212 at second node 214 and third driver 242 at third node 244. Stated differently, second leg 216 may be disposed between second driver 212 and third driver 242, connecting second node 214 to third node 244. Second leg 216 may include one or more MTJs connected in series connecting second node 214 to third node 244. A third leg 236 may be connected to third driver 242 at third node 244 and fourth driver 232 at fourth node 234. Stated differently, third leg 236 may be disposed between third driver 242 and fourth driver 232, connecting third node 244 to fourth node 234. Third leg 236 may include one or more MTJs connected in series connecting third node 244 to fourth node 234. A fourth leg 226 may be connected to fourth driver 232 at fourth node 234 and fifth driver 222 at fifth node 224. Stated differently, fourth leg 226 may be disposed between fourth driver 232 and fifth driver 222, connecting fourth node 234 to fifth node 224. Fourth leg 226 may include one or more MTJs connected in series connecting fourth node 234 to fifth node 224.

Each of the one or more MTJs of each leg (e.g., first leg 206, second leg 216, third leg 236, and fourth leg 226) may include one or more operating states. For example, an MTJ may operate in a low-resistance state (e.g., parallel) or high-resistance state (e.g., antiparallel). Based on the voltages applied at each node (which are supplied by the write drivers) and the resultant current, the state of each MTJ may be changed from parallel to antiparallel or vice versa. Each leg (e.g., first leg 206, second leg 216, third leg 236, and fourth leg 226) may include fewer or more MTJs relative to the examples explicitly discussed herein, and such modification may be consistent with the operation of the present embodiment without departing from the scope of the disclosure.

In an embodiment, the configuration bit may implement a two-phase (two-pass) program. Utilizing the two-phase program may provide the advantage of smaller components (e.g., write drivers) within configuration bit 200 as the amount of current required to be provided by the drivers would be smaller, along with the added benefit of using a pre-existing program signal to program each of the MTJs. The smaller components may lead to a reduction in the overall area for configuration bit 200. The two-phase program may include a first phase 201 to program a first portion of MTJs and a second phase 201' to program a second portion of the MTJs not programmed during the first phase 201. The correspondence between each phase of the two-phase program and the program signal 250, read signal 260, and data signal 270 is illustrated at the bottom portion of FIG. 2. The read signal 260 may be reused from a read operation (not shown) to avoid adding a logic control input, and it may be used to indicate the phase of programming. FIG. 2 illustrates one example of programming when the data signal is driven high.

During the first phase 201, a voltage may be applied to appropriate nodes to simultaneously program two legs of MTJs while inhibiting the other two legs of MTJs. During the second phase 201', a voltage may be applied to appropriate nodes to simultaneously program the two legs of MTJs which were inhibited during the first phase 201 and to inhibit the other two legs of MTJS which were programmed during the first phase 201.

For example, during the first phase 201, a same voltage (e.g., 0V) may be applied to first leg 206 through first driver 202 and second driver 212 connected to respective ends of first leg 206, which may cause the one or more MTJs of first leg 206 to be inhibited (e.g., to not draw current and thus not be programmed). More specifically, 0V may be applied at first node 204 and 0V may be applied at second node 214 and, as a result, little to no current may be drawn in first leg 206 as there would be no voltage difference between nodes 204 and 214, effectively inhibiting the one or more MTJs of first leg 206. Similarly, a same voltage (e.g., Vdd) may be applied to third leg 236 through third driver 242 and fourth driver 232 connected to respective ends of third leg 236, which may cause the one or more MTJs of third leg 236 to be inhibited (e.g., to not draw current and thus not be programmed). More specifically, Vdd may be applied at third node 244 and Vdd may be applied at fourth node 234 and, as a result, little to no current may be drawn in third leg 236 as there would be no voltage difference between nodes 244 and 234, effectively inhibiting the one or more MTJs of third leg 236. Concurrently, a different voltage (e.g., Vdd and 0V) may be applied to second leg 216 through second driver 212 and third driver 242 connected to respective ends of second leg 216, which may cause the one or more MTJs of second leg 216 to be programmed (e.g., draw current), thereby changing the operating states of each of the one or more MTJs of second leg 216 (e.g., from parallel to antiparallel). More specifically, 0V may be applied at second node 214 and Vdd may be applied at third node 244 and, as a result, a current may be drawn in second leg 216 as there would be a voltage difference between nodes 214 and 244, effectively programming the one or more MTJs of second leg 216. Similarly, a different voltage (e.g., Vdd and 0V) may be applied to fourth leg 226 through fourth driver 232 and fifth driver 222 connected to respective ends of fourth leg 226, which may cause the one or more MTJs of fourth leg 226 to be programmed (e.g., draw current), thereby changing the operating states of each of the one or more MTJs of fourth leg 226 (from antiparallel to parallel). More specifically, Vdd may be applied at fourth node 234 and 0V may be applied at fifth node 224 and, as a result, a current may be drawn in fourth leg 226 as there would be a voltage difference between nodes 234 and 224, effectively programming the one or more MTJs of fourth leg 226.

During the second phase 201', a different voltage (e.g., 0V and Vdd) may be applied to first leg 206' through first driver 202' and second driver 212' connected to respective ends of first leg 206', which may cause the one or more MTJs of first leg 206' to be programmed (e.g., draw current), thereby changing the operating states of each of the one more MTJs of first leg 206' (from parallel to antiparallel). More specifically, 0V may be applied at first node 204' and Vdd may be applied at second node 214' and, as a result, a current may be drawn in first leg 206' as there would be a voltage difference between nodes 204' and 214', effectively programming the one or more MTJs of first leg 206'. Similarly, a different voltage (e.g., Vdd and 0V) may be applied to third leg 236' through third driver 242' and fourth driver 232' connected to respective ends of third leg 236', which may cause the one or more MTJs of third leg 236' to be programmed (e.g., draw current), thereby changing the operating states of each of the one more MTJs of third leg 236' (from antiparallel to parallel). More specifically, Vdd may be applied at third node 244' and 0V may be applied at fourth node 234' and, as a result, a current may be drawn in third leg 236' as there would be a voltage difference between nodes 244' and 234', effectively programming the one or more MTJs of third leg 236'. Concurrently, a same voltage (e.g., Vdd) may be applied to second leg 216' through second driver 212' and third driver 242' connected to respective ends of second leg 216', which may cause the one or more MTJs of second leg 216' to be inhibited (e.g., to not draw current and thus not be programmed). More specifically, Vdd may be applied at second node 214' and Vdd may be applied at third node 244' and, as a result, little to no current may be drawn in second leg 216' as there would be no voltage difference between nodes 214' and 244', effectively inhibiting the one or more MTJs of second leg 216'. Similarly, a same voltage (e.g., 0V) may be applied to fourth leg 226' through fourth driver 232' and fifth driver 222' connected to respective ends of fourth leg 226', which may cause the one or more MTJs of fourth leg 226' to be inhibited (e.g., to not draw current and thus not be programmed). More specifically, 0V may be applied at fourth node 234' and 0V may be applied at fifth node 224' and, as a result, little to no current may be drawn in fourth leg 226' as there would be no voltage difference between nodes 234' and 224', effectively inhibiting the one or more MTJs of fourth leg 226'.

As described above, the second driver 212, the third driver 242, and the fourth driver 232 may each be connected to more than one leg of MTJs, and the first driver 202 and the fifth driver 222 may each be connected to only one leg of MTJs. Because only second leg 216 and fourth leg 226 are programmed during the first phase 201, and only first leg 206' and third leg 236' are programmed during the second phase 201', the two-phase program may avoid a scenario where current flows to more than one leg of MTJs through a single driver. Accordingly, all drivers (e.g., 202, 212, 242, 232, 222) may be designed (e.g., sized) to support substantially the same amount of current because no single driver would have to support a larger amount of current than the other drivers (e.g., all drivers would supply current to a single leg of MTJs at the same time). This may provide the benefit of decreasing the size of drivers 212, 242, 232, thereby reducing the overall area required by configuration bit 200.

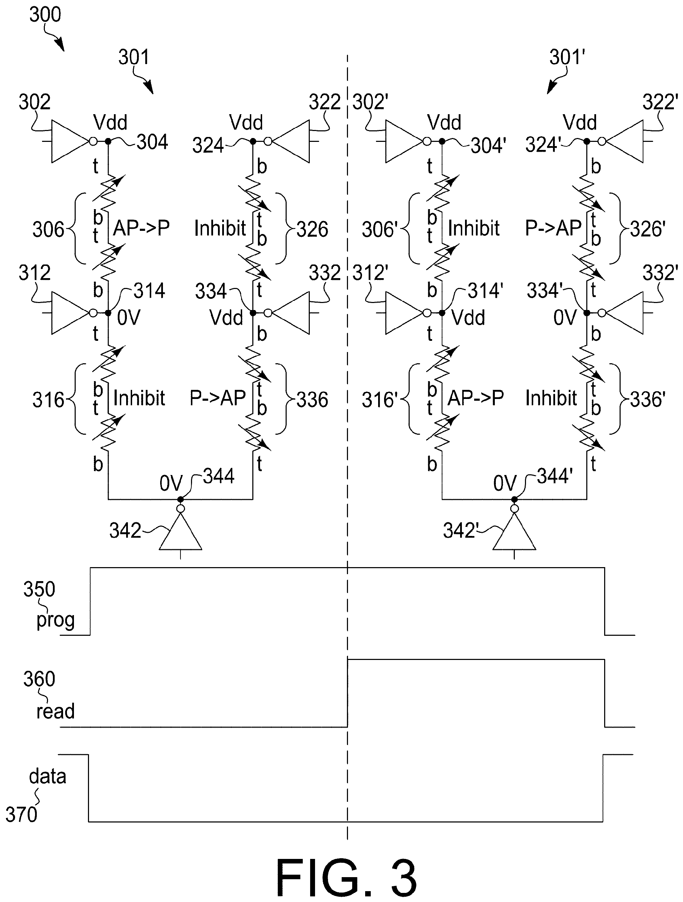

FIG. 3 depicts an exemplary circuit schematic of a configuration bit, according to one or more embodiments. A memory device 300 (e.g., configuration bit 300) may operate in substantially the same manner as configuration bit 200 described with respect to FIG. 2. Accordingly, it would be apparent to one of ordinary skill in art how configuration bit 300 operates based on the description provided in reference to FIG. 2. Nonetheless, it should be noted that FIG. 3 depicts a two-phase programming where a data signal 370 written to the configuration bit is 0, whereas FIG. 2 depicts a two-phase programming where the data signal 270 written to the configuration bit is 1. For example, after the programming operation of FIG. 2, the states of the first leg and the second leg may be antiparallel, whereas the states of the third leg and the fourth leg may be parallel. Inversely, after the programming operation of FIG. 3, the states of the first leg and the second leg may be parallel, whereas the states of the third leg and the fourth leg may be antiparallel. Configuration bit 300 may execute the two-phrase programming based on a program signal 350 and a read signal 360, similar to configuration bit 200. However, in the case of configuration bit 300 depicted in FIG. 3, the data signal 370 is zero, as the data to be written to the configuration bit is 0.

The inversed configuration may program the one or more MTJs of each leg using the two-phase programming operation as similarly described with respect to FIG. 2. For example, during the first phase 301, a different voltage (e.g., Vdd and 0V) may be applied to first leg 306 through first driver 302 and second driver 312 connected to respective ends of first leg 306, which may cause the one or more MTJs of first leg 306 to be programmed (e.g., draw current), thereby changing the operating states of each of the one more MTJs of first leg 306 (from antiparallel to parallel). More specifically, Vdd may be applied at first node 304 and 0V may be applied at second node 314 and, as a result, a current may be drawn in first leg 306 as there would be a voltage difference between nodes 304 and 314, effectively programming the one or more MTJs of first leg 306. Similarly, a different voltage (e.g., 0V and Vdd) may be applied to third leg 336 through third driver 342 and fourth driver 332 connected to respective ends of third leg 336, which may cause the one or more MTJs of third leg 336 to be programmed (e.g., draw current), thereby changing the operating states of each of the one more MTJs of third leg 336 (from parallel to antiparallel). More specifically, 0V may be applied at third node 344 and Vdd may be applied at fourth node 334 and, as a result, a current may be drawn in third leg 336 as there would be a voltage difference between nodes 344 and 334, effectively programming the one or more MTJs of third leg 336. Concurrently, a same voltage (e.g., 0V) may be applied to second leg 316 through second driver 312 and third driver 342 connected to respective ends of second leg 316, which may cause the one or more MTJs of second leg 316 to be inhibited (e.g., to not draw current and thus not be programmed). More specifically, 0V may be applied at second node 314 and 0V may be applied at third node 344 and, as a result, little to no current may be drawn in second leg 316 as there would be no voltage difference between nodes 314 and 344, effectively inhibiting the one or more MTJs of second leg 316. Similarly, a same voltage (e.g., Vdd) may be applied to fourth leg 326 through fourth driver 332 and fifth driver 322 connected to respective ends of fourth leg 326, which may cause the one or more MTJs of fourth leg 326 to be inhibited (e.g., to not draw current and thus not be programmed). More specifically, Vdd may be applied at fourth node 334 and Vdd may be applied at fifth node 324 and, as a result, little to no current may be drawn in fourth leg 326 as there would be no voltage difference between nodes 334 and 324, effectively inhibiting the one or more MTJs of fourth leg 326.

During the second phase 301', a same voltage (e.g., Vdd) may be applied to first leg 306' through first driver 302' and second driver 312' connected to respective ends of first leg 306', which may cause the one or more MTJs of first leg 306' to be inhibited (e.g., to not draw current and thus not be programmed). More specifically, Vdd may be applied at first node 304' and Vdd may be applied at second node 314' and, as a result, little to no current may be drawn in first leg 306' as there would be no voltage difference between nodes 304' and 314', effectively inhibiting the one or more MTJs of first leg 306'. Similarly, a same voltage (e.g., 0V) may be applied to third leg 336' through third driver 342' and fourth driver 332' connected to respective ends of third leg 336', which may cause the one or more MTJs of third leg 336' to be inhibited (e.g., to not draw current and thus not be programmed). More specifically, 0V may be applied at third node 344' and 0V may be applied at fourth node 334' and, as a result, little to no current may be drawn in third leg 336' as there would be no voltage difference between nodes 344' and 334', effectively inhibiting the one or more MTJs of third leg 336'. Concurrently, a different voltage (e.g., Vdd and 0V) may be applied to second leg 316' through second driver 312' and third driver 342' connected to respective ends of second leg 316', which may cause the one or more MTJs of second leg 316' to be programmed (e.g., draw current), thereby changing the operating states of each of the one or more MTJs of second leg 316' (e.g., from antiparallel to parallel). More specifically, Vdd may be applied at second node 314' and 0V may be applied at third node 344' and, as a result, a current may be drawn in second leg 316' as there would be a voltage difference between nodes 314' and 344', effectively programming the one or more MTJs of second leg 316'. Similarly, a different voltage (e.g., 0V and Vdd) may be applied to fourth leg 326' through fourth driver 332' and fifth driver 322' connected to respective ends of fourth leg 326', which may cause the one or more MTJs of fourth leg 326' to be programmed (e.g., draw current), thereby changing the operating states of each of the one or more MTJs of fourth leg 326' (from parallel to antiparallel). More specifically, 0V may be applied at fourth node 334' and Vdd may be applied at fifth node 324' and, as a result, a current may be drawn in fourth leg 326' as there would be a voltage difference between nodes 334' and 324', effectively programming the one or more MTJs of fourth leg 326'.

In FIG. 2, reference numbers for the components of memory device 200 during the first and second phases are distinguished by the presence or absence of a prime symbol. However, as would be understood by a person of ordinary skill in the art, the components identified in the first phase and those identified in the second phase represent the same physical elements. In other words, although the reference numbers differ to indicate a phase transition, components sharing the same numerical designation refer to the same component (e.g., driver 202 and driver 202' denote the same driver, etc.).

Similarly, in FIG. 3, reference numbers for the components of memory device 300 during the first and second phases are distinguished by the presence or absence of a prime symbol. However, as would be understood by a person of ordinary skill in the art, the components identified in the first phase and those identified in the second phase represent the same physical elements. In other words, although the reference numbers differ to indicate a phase transition, components sharing the same numerical designation refer to the same component (e.g., driver 302 and driver 302' denote the same driver, etc.).

Furthermore, although different reference numbers are used for the same components across FIGS. 2 and 3, this distinction is merely for illustrative purposes to indicate two different programming operations (e.g., one corresponding to writing a "0" and the other to writing a "1"). In FIGS. 2-3, Components sharing the same last two digits in their reference numbers refer to the same physical component (e.g., driver 202 and driver 302 denote the same driver, driver 202' and driver 302' denote the same driver, etc.).

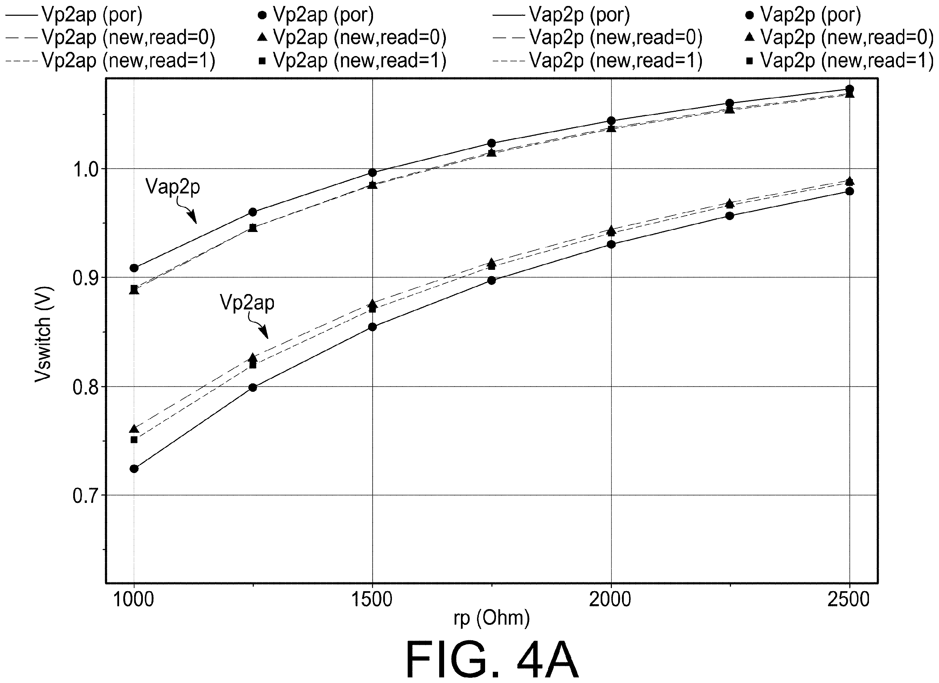

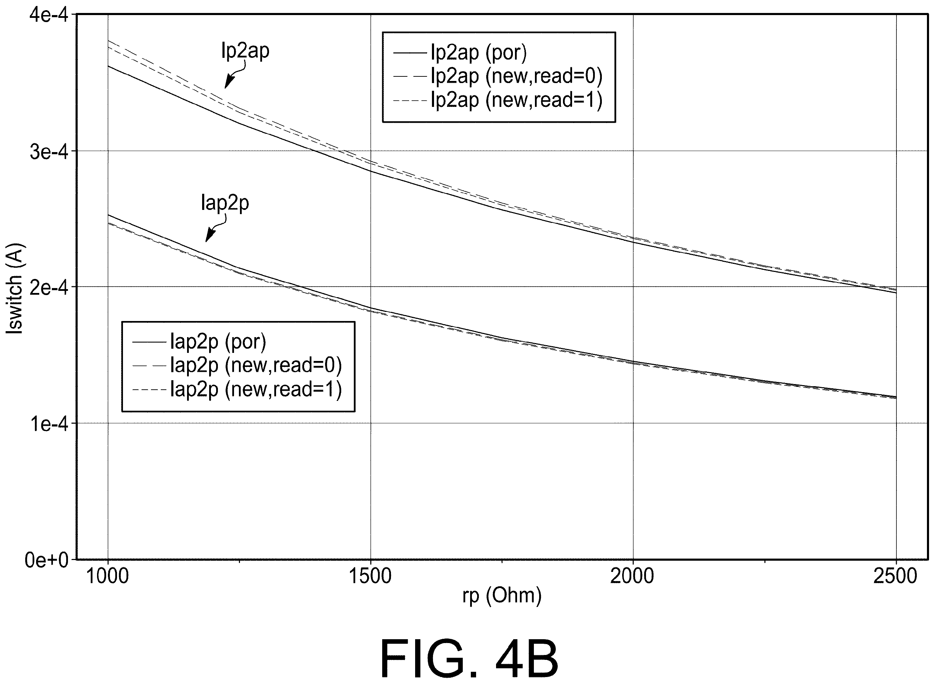

FIGS. 4A and 4B illustrate measurements from a configuration bit during a two-pass program as described herein with respect to FIGS. 2 and 3. In FIGS, 4A-4B, the measurements of the configuration bit implementing the two-pass program are compared to the measurements taken from a configuration bit configured to program all MTJs at the same time as described in reference to FIG. 1. As shown in FIGS. 4A and 4B, the switching voltages and switching currents measured from a single-pass (or single-phase) memory device (e.g., FIG. 1) are substantially similar to those measured from a two-pass (or two-phase) memory device (FIGS. 2-3). This indicates that the two-pass programming technique largely preserves the switching voltage and current levels typically required for single-pass programming.

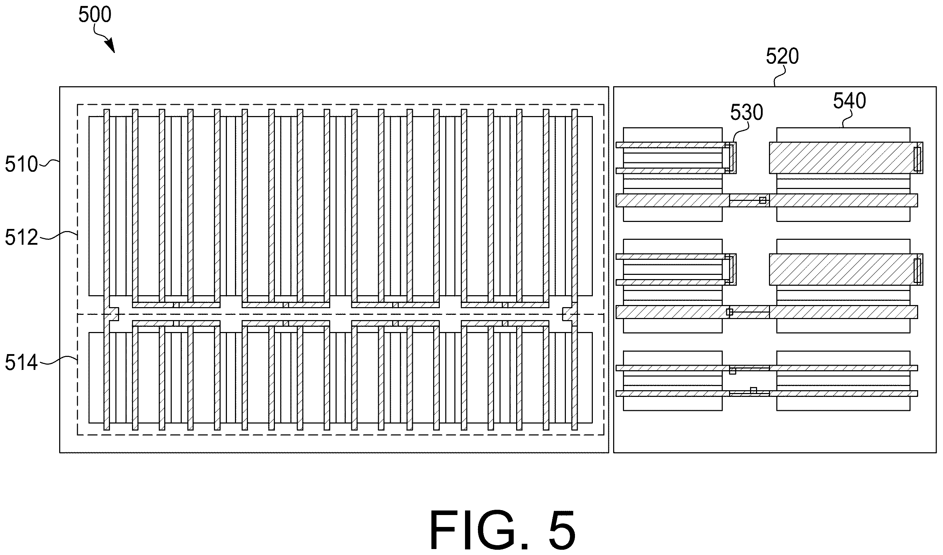

FIG. 5 illustrates a layout of a memory device 500. Memory device 500 (e.g., configuration bit 500, similar to or same as the ones described in reference to FIGS. 1-3) may include a program circuit 510 and a read circuit 520 arranged orthogonally to each other. The program circuit 510 may include one or more p-channel metal-oxide-semiconductors 512 (pmos) and one or more n-channel metal-oxide-semiconductors 514 (nmos). Program devices of the program circuit 510 may be arranged vertically. Program circuit 510 may include one or more configuration bits as described in FIGS. 1-3. Read circuit 520 may include one or more read devices (e.g., latches). Read devices of the read circuit 520 may be arranged horizontally. Read circuit 520 may include a poly arrangement 530 and a diffusion area 540. Diffusion area 540 may include an active region of the configuration bit device, and poly arrangement 530 may include one or more polysilicon gate structures. Diffusion area 540 may include one or more transistors (not shown), but embodiments are not limited thereto.

In an embodiment, write drivers (not shown) within program circuit 510 may maintain standard pitch orientation and transistor dimensions. In an embodiment, program circuit 510 may require drive strength and may benefit from merging fingers as in the standard cell area. In an embodiment, read circuit 520 (e.g., read latch) may be mis-match sensitive and may require different length devices and different width for each device (e.g., nmos vs. pmos). In an embodiment, program devices within the program circuit 510 may benefit from flexible placement in a vertical direction to allow for proper length sizing and abutment of shared diffusion from read circuit 520. This may provide the advantage of flexible sizing of diffusion area 540 width while maintaining the standard cell height. In an embodiment, program circuit 510 and read circuit 520 may maintain standard cell height while optimizing overall area, thereby reducing the overall silicon wafer area consumed for memory device 500.

In one embodiment, the present disclosure is drawn to a method of programming a configuration bit including magnetic tunnel junctions (MTJs), the method comprising: during a first phase: applying a first voltage to a first leg of MTJs and a third leg of MTJs to program or inhibit one or more MTJs of the first leg of MTJs and one or more MTJs of the third leg of MTJs, and applying a second voltage to a second leg of MTJs and a fourth leg of MTJs to program or inhibit one or more MTJs of the second leg of MTJs and one or more MTJs of the fourth leg of MTJs, and during a second phase: applying the second voltage to the first leg of MTJs and the third leg of MTJs to program or inhibit the one or more MTJs of the first leg of MTJs and the one or more MTJs of the third leg of MTJs, and applying the first voltage to the second leg of MTJs and the fourth leg of MTJs to program or inhibit the one or more MTJs of the second leg of MTJs and the one or more MTJs of the fourth leg of MTJs.

Various aspects of the present disclosure may also include: wherein inhibiting the one or more MTJs of the first leg of MTJs, the one or more MTJs of the second leg of MTJs, the one or more MTJs of the third leg of MTJs, or the one or more MTJs of the fourth leg of MTJs includes: maintaining a state of each of the one or more MTJs of the first leg of MTJs, the one or more MTJs of the second leg of MTJs, the one or more MTJs of the third leg of MTJs, or the one or more MTJs of the fourth leg of MTJs; wherein programming the one or more MTJs of the first leg of MTJs, the one or more MTJs of the second leg of MTJs, the one or more MTJs of the third leg of MTJs, or the one or more MTJs of the fourth leg of MTJs includes: changing a state of each of the one or more MTJs of the first leg of MTJs, the one or more MTJs of the second leg of MTJs, the one or more MTJs of the third leg of MTJs, or the one or more MTJs of the fourth leg of MTJs; wherein the first voltage and the second voltage are different; wherein, during the first phase, a state of the one or more MTJs of the second leg of MTJs and a state of the one or more MTJs of the fourth leg of MTJs change in response to applying the second voltage; wherein, during the second phase, a state of the one or more MTJs of the first leg of MTJs and a state of the one or more MTJs of the third leg of MTJs change in response to applying the second voltage; wherein, during the first phase, a state of the one or more MTJs of the first leg of MTJs and a state of the one or more MTJs of the third leg of MTJs are maintained in response to applying the first voltage; and during the second phase, a state of the one or more MTJs of the second leg of MTJs and a state of the one or more MTJs of the fourth leg of MTJs are maintained in response to applying the first voltage; wherein one of the first voltage or the second voltage is approximately 0 and the other of the first voltage or the second voltage is a supply voltage; and wherein each of the first leg of MTJs, the second leg of MTJs, the third leg of MTJs, and the fourth leg of MTJs is connected to a corresponding pair of write drivers.

In another embodiment, the present disclosure is drawn to a storage device, comprising: a configuration bit including: a first leg of magnetic tunnel junctions (MTJs); and a second leg of MTJs; wherein each of the first leg of MTJs and the second leg of MTJs includes at least four MTJs, and wherein the configuration bit is configured to program at least two MTJs in each of the first leg of MTJs and the second leg of MTJs while simultaneously inhibiting from programming at least two other MTJs in each of the first leg of MTJs and the second leg of MTJs.

Various aspects of the present disclosure may also include: wherein the storage device further comprises a plurality of drivers including a first driver, a second driver, a third driver, a fourth driver, and a fifth driver, wherein the first leg of MTJs is connected to the first driver, the second driver, and the third driver, and wherein the second leg of MTJs is connected to the third driver, the fourth driver, and the fifth driver; wherein the configuration bit is configured to program the at least two MTJs in each of the first leg of MTJs and the second leg of MTJs based on applying different voltages across the at least two MTJs in each of the first leg of MTJs and the second leg of MTJs; wherein the configuration bit is configured to inhibit from programming the at least two other MTJs in each of the first leg of MTJs and the second leg of MTJs based on applying same voltages across the at least two other MTJs in each of the first leg of MTJs and the second leg of MTJs; wherein the configuration bit is configured to program the at least two MTJs in each of the first leg of MTJs and the second leg of MTJs based on changing a state of the at least two MTJs in each of the first leg of MTJs and the second leg of MTJs to a high resistance state or a low resistance state; and wherein the configuration bit is configured to inhibit from programming the at least two other MTJs in each of the first leg of MTJs and the second leg of MTJs based on maintaining a state of the at least two other MTJs in each of the first leg of MTJs and the second leg of MTJs.

In yet another embodiment, the present disclosure is drawn to a memory device, comprising: a program circuit, wherein the program circuit includes one or more configuration bits, wherein each of the one or more configuration bits includes one or more magnetic tunnel junctions (MTJs); a read circuit, wherein the read circuit includes one or more latching devices; a poly arrangement; and a diffusion area, wherein the read circuit is disposed perpendicular to the program circuit.

Various aspects of the present disclosure may also include: wherein the poly arrangement includes polysilicon interconnections, and wherein the diffusion area includes an active region covering at least a portion of the one or more configurations bits; wherein, by disposing the read circuit perpendicular to the program circuit, a total area of the program circuit and the read circuit within the memory device is reduced; wherein the diffusion area includes a height and a width, and wherein the height of the diffusion area is maintained and the width of the diffusion area is adjusted to increase an active region between the program circuit and the read circuit; and wherein the read circuit is mis-match sensitive allowing for a length and a width of each of the one or more latching devices to be adjusted to increase an active region of the diffusion area.

Other embodiments of the disclosure will be apparent to those skilled in the art from consideration of the specification and practice of the embodiment(s) disclosed herein. It is intended that the specification and examples may be considered as exemplary only, with a true scope and spirit of the embodiment(s) being indicated by the following claims.

While exemplary embodiments have been presented above, it should be appreciated that many variations exist. Furthermore, while the description includes references to memory cells and devices, the teachings may be applied to other memory devices having different architectures in which the same concepts can be applied. Thus, the particular embodiments disclosed above are illustrative only and should not be taken as limitations, as the embodiments may be modified and practiced in different but equivalent manners apparent to those skilled in the art having the benefit of the teachings herein. Accordingly, the foregoing description is not intended to limit the disclosure to the particular form set forth, but on the contrary, is intended to cover such alternatives, modifications and equivalents as may be included within the spirit and scope of the inventions as defined by the appended claims so that those skilled in the art should understand that they can make various changes, substitutions and alterations without departing from the spirit and scope of the inventions in their broadest form.

For example, in one embodiment, one or more of the MTJs connected in series between one or more nodes of the configuration bit may be unprogrammable and/or one-time only programmable (e.g., one-time programmed or programmable at manufacture, test or initialization). In this regard, with reference to FIG. 1, the MTJ(s) between one or more of nodes may be unprogrammable and/or one-time only programmable - for example, in one exemplary embodiment, one or more (or all) of the MTJs of the first leg 106 (i.e., between first node 104 and second node 114) may be unprogrammable and/or one-time only programmable; in another embodiment, one or more (or all) of the MTJs of the first leg 106 and one or more (or all) of the MTJs of the second leg 116 may be unprogrammable and/or one-time only programmable. Indeed, in yet another embodiment, one or more (or all) of the MTJs of the third leg 136 may be unprogrammable and/or one-time only programmable and one or more (or all) of the MTJs of the fourth leg 126 may be unprogrammable and/or one-time only programmable.

It may be advantageous to employ a midpoint sensing technique, via midpoint sensing circuitry, to detect or sense the data state of the configuration bit where one or more unprogrammable and/or one-time only programmable MTJs act or function as a reference resistor for sensing. In alternate embodiments, an actual resistor made of poly, metal, well, or diffusion, may be used in lieu of one or more unprogrammable and/or one-time only programmable MTJs.

In one embodiment, the one or more unprogrammable and/or one-time only programmable MTJs may be employed to provide or make the configuration bit circuit a one-time only programmable bit to store secure data which cannot thereafter be modified - thereby providing a one-time only programmable bit cell (e.g., one-time only programmed or programmable at manufacture, test or initialization).

Notably, for the avoidance of doubt, the embodiments including one or more unprogrammable and/or one-time only programmable MTJs described immediately above may be implemented in conjunction with each and every embodiment described herein and in connection with one or more (or all) of the configuration bits of the integrated circuit die or chip.

The foregoing description of the inventions has been described for purposes of clarity and understanding. It is not intended to limit the inventions to the precise form disclosed. Various modifications may be possible within the scope and equivalence of the application.

## Claims

1. A method of programming a configuration bit including magnetic tunnel junctions (MTJs), the method comprising:
during a first phase:
applying a first voltage to a first leg of MTJs and a third leg of MTJs to program or inhibit one or more MTJs of the first leg of MTJs and one or more MTJs of the third leg of MTJs, and
applying a second voltage to a second leg of MTJs and a fourth leg of MTJs to program or inhibit one or more MTJs of the second leg of MTJs and one or more MTJs of the fourth leg of MTJs, and
during a second phase:
applying the second voltage to the first leg of MTJs and the third leg of MTJs to program or inhibit the one or more MTJs of the first leg of MTJs and the one or more MTJs of the third leg of MTJs, and
applying the first voltage to the second leg of MTJs and the fourth leg of MTJs to program or inhibit the one or more MTJs of the second leg of MTJs and the one or more MTJs of the fourth leg of MTJs.

2. The method of claim 1, wherein inhibiting the one or more MTJs of the first leg of MTJs, the one or more MTJs of the second leg of MTJs, the one or more MTJs of the third leg of MTJs, or the one or more MTJs of the fourth leg of MTJs comprises: maintaining a state of each of the one or more MTJs of the first leg of MTJs, the one or more MTJs of the second leg of MTJs, the one or more MTJs of the third leg of MTJs, or the one or more MTJs of the fourth leg of MTJs.

3. The method of any of the preceding claims, wherein programming the one or more MTJs of the first leg of MTJs, the one or more MTJs of the second leg of MTJs, the one or more MTJs of the third leg of MTJs, or the one or more MTJs of the fourth leg of MTJs comprises:
changing a state of each of the one or more MTJs of the first leg of MTJs, the one or more MTJs of the second leg of MTJs, the one or more MTJs of the third leg of MTJs, or the one or more MTJs of the fourth leg of MTJs.

4. The method of any of the preceding claims, wherein the first voltage and the second voltage are different.

5. The method of any of the preceding claims, wherein, during the first phase, a state of the one or more MTJs of the second leg of MTJs and a state of the one or more MTJs of the fourth leg of MTJs change in response to applying the second voltage and/or
wherein, during the second phase, a state of the one or more MTJs of the first leg of MTJs and a state of the one or more MTJs of the third leg of MTJs change in response to applying the second voltage.

6. The method of any of the preceding claims, wherein, during the first phase, a state of the one or more MTJs of the first leg of MTJs and a state of the one or more MTJs of the third leg of MTJs are maintained in response to applying the first voltage; and
during the second phase, a state of the one or more MTJs of the second leg of MTJs and a state of the one or more MTJs of the fourth leg of MTJs are maintained in response to applying the first voltage.

7. The method of any of the preceding claims, wherein one of the first voltage or the second voltage is approximately 0 and the other of the first voltage or the second voltage is a supply voltage, and/or wherein each of the first leg of MTJs, the second leg of MTJs, the third leg of MTJs, and the fourth leg of MTJs is connected to a corresponding pair of write drivers.

8. A storage device, comprising:
a configuration bit including:
a first leg of magnetic tunnel junctions (MTJs); and
a second leg of MTJs;
wherein each of the first leg of MTJs and the second leg of MTJs includes at least four MTJs, and
wherein the configuration bit is configured to program at least two MTJs in each of the first leg of MTJs and the second leg of MTJs while simultaneously inhibiting from programming at least two other MTJs in each of the first leg of MTJs and the second leg of MTJs,
the storage device, in particular, further comprising:
a plurality of drivers including a first driver, a second driver, a third driver, a fourth driver, and a fifth driver,
wherein the first leg of MTJs is connected to the first driver, the second driver, and the third driver, and
wherein the second leg of MTJs is connected to the third driver, the fourth driver, and the fifth driver.

9. The storage device of claim 8, wherein the configuration bit is configured to program the at least two MTJs in each of the first leg of MTJs and the second leg of MTJs based on applying different voltages across the at least two MTJs in each of the first leg of MTJs and the second leg of MTJs.

10. The storage device of claim 8, wherein the configuration bit is configured to inhibit from programming the at least two other MTJs in each of the first leg of MTJs and the second leg of MTJs based on applying same voltages across the at least two other MTJs in each of the first leg of MTJs and the second leg of MTJs, and/or
wherein the configuration bit is configured to program the at least two MTJs in each of the first leg of MTJs and the second leg of MTJs based on changing a state of the at least two MTJs in each of the first leg of MTJs and the second leg of MTJs to a high resistance state or a low resistance state.

11. The storage device of claim 8, wherein the configuration bit is configured to inhibit from programming the at least two other MTJs in each of the first leg of MTJs and the second leg of MTJs based on maintaining a state of the at least two other MTJs in each of the first leg of MTJs and the second leg of MTJs.

12. A memory device, comprising:
a program circuit, wherein the program circuit includes one or more configuration bits, wherein each of the one or more configuration bits includes one or more magnetic tunnel junctions (MTJs);
a read circuit, wherein the read circuit includes one or more latching devices;
a poly arrangement; and
a diffusion area,
wherein the read circuit is disposed perpendicular to the program circuit.

13. The memory device of claim 12, wherein the poly arrangement includes polysilicon interconnections, and
wherein the diffusion area includes an active region covering at least a portion of the one or more configurations bits, in particular, wherein, by disposing the read circuit perpendicular to the program circuit, a total area of the program circuit and the read circuit within the memory device is reduced.

14. The memory device of claim 12 or 13, wherein the diffusion area includes a height and a width, and
wherein the height of the diffusion area is maintained and the width of the diffusion area is adjusted to increase an active region between the program circuit and the read circuit.

15. The memory device of any of claims 12, 13, or 14, wherein the read circuit is mis-match sensitive allowing for a length and a width of each of the one or more latching devices to be adjusted to increase an active region of the diffusion area.
